# EUROPEAN PATENT APPLICATION

(11) **EP 4 764 702 A1**
(43) Date of publication of application: **24.06.2026**
(21) Application number: 24307259.2
(22) Date of filing: 20.12.2024
(51) Int. Cl.: G03F 7/00, G01N 21/956, G02B 21/00, G02B 27/00

(54) **METHOD AND DEVICE FOR DETERMINING RELATIVE LATERAL DATA OF SEMICONDUCTOR STRUCTURES**

(71) Applicant: UNITY SEMICONDUCTOR, 38330 Montbonnot-Saint-Martin (FR)
(72) Inventor: HAKOBYAN, Davit, 38330 Saint Ismier (FR); ALLIATA, Dario, 38000 Grenoble (FR); BENHADJSALEM, Kaiss, 38360 Sassenage (FR)
(74) Representative: IPAZ

(57) **Abstract**

The invention relates to a method (200) for determining relative lateral data of features of a semiconductor substrate, the method (200) being implemented by a device comprising:
- an imaging system (11, 13, 14, 16) having a depth of field,
- a spatial phase mask (17) positioned in the aperture stop of the imaging system or in a conjugate plane of the aperture stop and configured to modulate the optical transfer function of the imaging system, and
- an image sensor (12),
wherein the modulated optical transfer function is adapted to extend the depth of field of the imaging system,
the method (200) comprising the following steps:
- acquiring (202) an image of a scene comprising at least a first feature of the semiconductor substrate in a first plane and a second feature of the semiconductor substrate in a second plane, the planes being perpendicular to an optical axis of the imaging system and separated by a distance greater than the depth of field of the imaging system;
- detecting (204) the first feature of the semiconductor substrate and the second feature of the semiconductor substrate;
- determining (206) relative lateral data of the first feature and the second feature.

The invention also relates to a device implementing such a method.

## Description

### Field of the invention

The present invention relates to a method for determining relative lateral data of features of semiconductor substrates. The invention also relates to a device implementing such a method.

The field of the invention is the field of inspection and characterization of semiconductor substrates and components by optical methods.

### Background

Semiconductor components are increasingly composed of a superposition of elements stacked on each other, in order to realize complex functions at the chip level through three-dimensional architectures.

It is, for instance, known to stack electronic circuits, or dies, on each other. These dies can comprise elements of memory (High Bandwidth Memory, HBM) which are stacked on a logic chip. The bonding between the stacked elements can be realized by thermos-compression bonding, or hybrid bonding. The assembly can be realized at the wafer level (wafer to wafer) or at the die level (die to wafer or die to die). It is also possible to place intermediate interconnection elements between stacked circuit elements. Vertical connection lines may also be etched at precise locations.

For these processes, it is essential to verify that the different elements have the correct dimensions and are perfectly aligned with respect to each other. It is also important to ensure that the electrical connections between the elements are functioning properly and are well connected to each other.

In order to control the alignment between vertically stacked layers, dies, patterns, or structures, overlay measurements are carried out. The measurement of the relative positions of these vertically stacked elements provides a so-called overlay error.

It is known to perform overlay measurements by microscopy, in transmission mode at wavelengths such as infrared for silicon, or in reflection mode using visible light. Patterns belonging to respective stacked elements may thus be imaged, and their respective lateral positions compared.

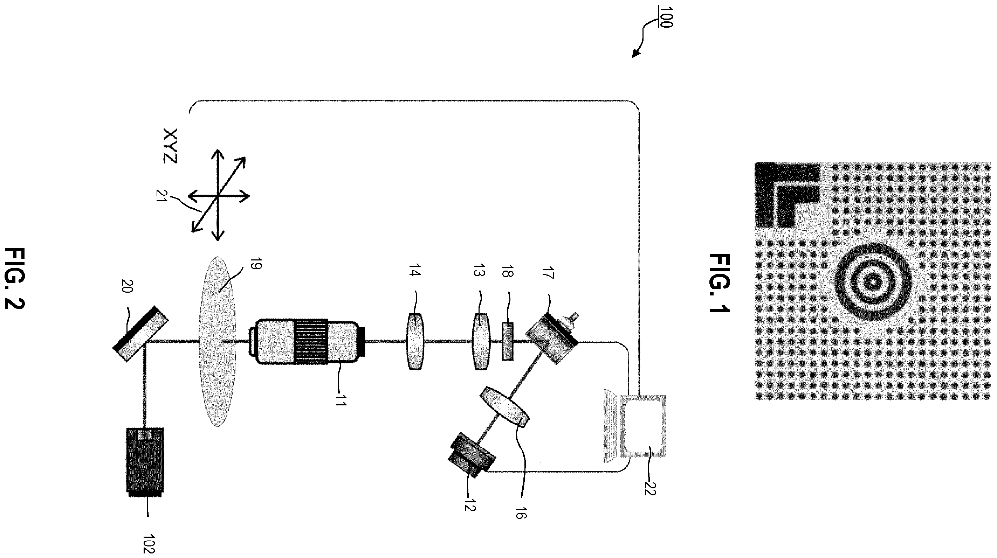

For example, for a die stacked on a wafer, both the die and wafer may present alignment mark. An example of different substrates stacked together is shown in FIGURE 1. A die is stacked on a wafer, and both the die and the wafer carry both circular and angled alignment marks. An overlay measurement is then used to estimate the concentricity and the angular alignment of the different alignment marks, allowing for calculating both lateral distance and angular error.

In such overlay measurements, the lateral dimensions of the features to be measured are usually in the micrometre to tens of micrometre range. Thus, proper imaging requires high-resolution and high-magnification imaging optics. To achieve this, objectives with a large numerical aperture (NA) are implemented. However, the depth of field (DoF) decreases as the NA increases. For high-NA optics, the DoF is, for example, in the range of some micrometres, and therefore cannot accommodate several planes of structures.

Therefore, such known systems for measuring the overlay error are adapted only when the features to image for comparing their respective positions are mostly in the same plane.

However, in several cases it is necessary to measure the relative position of features located in planes separated by more than the DoF of the optical system. For example, different features may be located in planes that are separated by several of micrometres.

In this case, several images may be acquired by sequentially positioning the object plane, within the DoF, at different depth, and picking the images where the respective features of interest are at best focus. This technique requires an increased measurement time because of the multiple image acquisitions. Additionally, multiple errors may occur with the data processing and during scanning, leading to less accurate overlay measurements.

### Summary of the invention

A purpose of the present invention is to overcome at least one of the drawbacks of the known technique.

A purpose of the present invention is to propose a solution to determine relative lateral data of semiconductor-substrate features located in different object planes separated by more than the depth of field of the imaging optics.

Another purpose of the present invention is to propose a solution to determine relative lateral data of semiconductor-substrate features, located in different object planes separated by more than the depth of field of the imaging optics, more efficiently and/or faster.

Another purpose of the present invention is to propose a solution to determine relative lateral data of such semiconductor-substrate features, located in different object planes separated by more than the depth of field of the imaging optics, more accurately and with minimized error.

At least one of these aims is achieved by a method for determining relative lateral data of features of a semiconductor substrate, the method being implemented by a device comprising:
- an imaging system having a depth of field,
- a spatial phase mask positioned in the aperture stop of the imaging system or in a conjugate plane of the aperture stop and configured to modulate the optical transfer function of the imaging system, and
- an image sensor,

wherein the modulated optical transfer function is adapted to extend the depth of field of the imaging system,
the method comprising the following steps:
   - acquiring an image of a scene comprising at least a first feature of the semiconductor substrate in a first plane and a second feature of the semiconductor substrate in a second plane, the planes being perpendicular to an optical axis of the imaging system and separated by a distance greater than the depth of field of the imaging system;
   - detecting the first feature of the semiconductor substrate and the second feature of the semiconductor substrate;
   - determining relative lateral data of the first feature and the second feature.

In the method according to the present invention, an image of a first and a second feature of a semiconductor substrate is acquired by a device with an imaging system. The first feature is located in a first plane and the second feature is located in a second plane, the planes being separated by a distance greater than the depth of field of the imaging system. Thanks to the provision of a spatial phase mask in the aperture plane of the imaging system or in the conjugate plane of the aperture plane and configured to modulate the optical transfer function of the imaging system, the depth of field of the imaging system is extended with respect to its initial depth of field.

Of course, the method according to invention can be used in the same way to determine relative data of features located in the same plane or in planes separated by a distance smaller than the depth of field of the imaging system.

Thanks to the provision of a spatial phase mask, the depth of field is controlled and significantly extended by modifying the impulse response, or point spread function, of the imaging system.

The depth of field can be defined as the range along the optical axis in which spatial frequencies of the features present on the substrate higher than a threshold or a cut-off frequency defined according to any criterion can be acquired by the image sensor. The depth of field is, of course, related to how the point spread function evolves along the optical axis. The spatial phase mask is designed to provide, in combination with the imaging system, a point spread function which evolves differently along the optical axis, so that the range, or depth of field, in which the maximum spatial frequency transmitted to the image sensor is higher than a threshold is longer than for the imaging system without a spatial phase mask.

The first and second features are accommodated by the extended depth of field and may therefore be imaged simultaneously in one and the same image. In fact, multiple planes may be imaged simultaneously in a single image. Therefore, no sequential scanning of the imaging system or displacement of the semiconductor substrate is necessary.

Thanks to the extended depth of field, the image quality is maintained at an acceptable or sufficient resolution over a larger range of depths than without the spatial phase mask. It is for instance not necessary to modify the numerical aperture of the imaging system to achieve this. The extended depth of field may, for example, be five times larger than the initial depth of field of the imaging system.

Further, the acquisition or measurement time is significantly reduced and the throughput increased.

The acquired image is then processed to detect the features and determine relative lateral data of them. Since only one image is to be processed, the risk of errors is minimized when determining the relative lateral data. Thanks to the extended depth of field, the determination of the relative lateral data is more insensitive to the distance of the imaged planes than conventional methods.

Measurement of relative lateral data may include measurements of overlay, relative position, critical or lateral dimensions, etc.

In the present document, the term "feature" refers to structures, surfaces, patterns, alignment marks, and the like, positioned on one or more semiconductor substrates. Structures may include etched structures like vias, holes, and trenches. "Features" may also designate layers such as dies or electronic circuits, and the like.

The features of which a relative lateral data is to be determined are located in different planes within the extended depth of field. These features may be located on the same or on different semiconductor substrates. For example, features may be located in different layers of a semiconductor substrate.

With the method according to the invention, the relative lateral data of two or more features located in different depths may be determined.

In the present document, the "imaging system" concerned by the extension of the depth of field may refer to an objective and/or any other set of lenses present in the device and involved in imaging the feature(s) on the imaging sensor.

In the present document, the terms "top" or "top side" of a semiconductor substrate correspond to the side or to the surface on which the features are located or deposited. In particular, the "top" corresponds to the side on which vias, etc. are etched.

The term "bottom" or "bottom side" corresponds to the side of the semiconductor substrate opposite to the top side.

According to an embodiment, the relative lateral data may comprise relative lateral dimensions of the first and second feature, respectively.

The sizes of the features may thus be compared using a single image.

The relative lateral data may also comprise relative lateral positions of the first and second feature, respectively.

Accurate relative lateral positioning is particularly important when different layers or structures, such as dies on a wafer, are stacked together.

According to an embodiment, the method may further comprise a step of determining an overlay error from the relative lateral data.

The overlay error is evaluated from the relative positions of the features, such as structures or patterns.

According to an embodiment, the method may further comprise a step of determining a shape of the first feature and/or the second feature.

According to an embodiment, the method may further comprise a step of deconvoluting the acquired image using a deconvolution filter.

The deconvolution step allows for further increasing the image quality.

Of course, other post-processing techniques may be implemented in addition or alternatively to increase the image quality.

According to another aspect of the same invention, it is proposed a device for determining relative lateral data of features of a semiconductor substrate, comprising:
- an imaging system having a depth of field;
- a spatial phase mask positioned in the aperture stop of the imaging system or in a conjugate plane of the aperture stop, the spatial phase mask being configured to modulate the optical transfer function of the imaging system, wherein the modulated optical transfer function is adapted to extend the depth of field of the imaging system;
- an image sensor for acquiring, through the imaging system, an image of a scene comprising at least a first feature of the semiconductor substrate in a first plane and a second feature of the semiconductor substrate in a second plane, the planes being perpendicular to an optical axis of the imaging system and are separated by a distance greater than the depth of field of the imaging system;
- processing means configured to:
   - detect the first feature of the first semiconductor substrate and the second feature of the second semiconductor substrate,
   - determine relative lateral data of the first feature and the second feature.

According to an embodiment, the spatial phase mask may be realized on a fused silica substrate.

Such static spatial phase masks may be easily manufactured.

Alternatively, the spatial phase mask may comprise a dynamic phase modulator.

It is thus possible to dynamically control the spatial phase mask design. This allows for real-time tuning of the extension of the depth of field to be adapted to the desired application.

An example of a dynamic phase modulator is a spatial light modulator.

The spatial phase mask comprises one of:
- an binary phase mask,
- a cubic phase mask,
- a polynomial phase mask.

The choice of an architecture depends on the performance requirements and/or the specific application.

Among the mentioned designs, the binary phase mask, consisting of concentric rings with alternating phase shifts, is both cost-effective and efficient. It is easier to manufacture compared to more complex mask designs.

The cubic phase mask provides a more gradual transition between in-focus and out-of-focus regions.

The polynomial phase mask allows a highly customized modulation of the wavefront.

According to still another aspect of the same invention, it is proposed an imaging microscope comprising a light source and a device according to the invention.

The imaging microscope, implementing a method according to the invention, may be used in semiconductor metrology in order to determine relative lateral data of features in a fast, convenient, and accurate manner.

### Description of the figures and embodiments

Other advantages and characteristics will become apparent on examination of the detailed description of an embodiment which is in no way limitative, and the attached figures, where:
- FIGURE 1 shows an example of different substrates stacked on one another and carrying alignment marks;
- FIGURE 2 is a diagrammatic representation of a non-limitative example of an imaging microscope according to the present invention;
- FIGURE 3 shows an example of a modified transfer function using a spatial phase mask;
- FIGURE 4 shows an example of a binary spatial phase mask that may be implemented in a method and a device according to an embodiment of the invention;
- FIGURE 5 illustrates a method for determining relative lateral data of features of a semiconductor substrate according to an embodiment of the present invention;
- FIGURE 6 illustrates examples of implementations of the method and the device according to the present invention; and
- FIGURE 7 shows an example of the determination of an overlay error by means of the method and the device according to embodiments of the present invention.

It is well understood that the embodiments that will be described below are in no way limitative. In particular, it is possible to imagine variants of the invention comprising only a selection of the characteristics described hereinafter, in isolation from the other characteristics described, if this selection of characteristics is sufficient to confer a technical advantage or to differentiate the invention with respect to the state of the prior art. Such a selection comprises at least one, preferably functional, characteristic without structural details, or with only a part of the structural details if this part alone is sufficient to confer a technical advantage or to differentiate the invention with respect to the prior art.

In the FIGURES, elements common to several figures may keep the same reference.

FIGURE 2 is a diagrammatic representation of a non-limitative example of an imaging microscope according to the present invention.

The imaging microscope 100 implements a device determining relative lateral data of features of a semiconductor substrate according to the present invention.

The imaging microscope 100 according to the embodiment as represented in FIGURE 2 comprises an imaging objective 11.

A 4f-system consisting to two lenses 14, 15 is used to reimage the objective's exit pupil, which is in the embodiment shown the aperture stop, for placing a spatial phase mask 17 as detailed below.

The microscope 100 comprises a tube lens 16 for focusing the light onto the camera 12.

The imaging objective 11, the 4f-system, and the tube lens 16 form an imaging system having a defined depth of field.

The depth of field, also referred to as focusing depth or depth of focus, and as referred to within this document, is defined as the longitudinal interval of the image space of the imaging system for which no or acceptable blurring occurs in the captured image. In the object space, the depth of field of the imaging system is defined as the conjugate of the depth of focus in the image space. The depth of focus depends on the specifications of the imaging system, such as the focal length, object-image optical conjugation, numerical aperture, on the wavelength of the light beam, and on the pixel size of the image sensor.

A spatial phase mask 17 is positioned in a plane optically conjugate of the exit pupil of the objective 11 by the lenses 14, 15, so that it works optically as if it was positioned directly in the exit pupil of that objective, forming the aperture stop of the imaging system. The aperture stop can be the exit pupil of the objective (on the object side).

In the example as shown in FIGURE 2, the spatial phase mask is a dynamic phase modulator. The dynamic phase modulator 17 may be, for example, a spatial light modulator (SLM). In the device as represented, the SLM 17 is combined with a linear polarizer 18 in order to optimize the phase mask efficiency.

The imaging microscope comprises a camera 12, as an image sensor. The camera 12 is configured to capture or acquire at least one image of a substrate, such as a wafer 19.

The wafer 19 is preferably mounted on a displaceable support such as a precision stage 21, allowing for moving it in the X, Y, and Z directions.

A light source 102 is arranged at the bottom or back side of the wafer 19. The wavelength(s) emitted by the light source 102 are adapted to be transmitted through the material of the wafer 19. For instance, if the wafer is of silicon, the light source shall emit light with wavelengths longer than 1µm or 1.1µm. The light source may be, for example, a light emitting diode (LED) emitting at 1075 nm. In the example represented in FIGURE 2, the light emitted from the light source 102 is directed through the wafer 19 using a mirror 20.

Alternatively, or in addition, a light source may also be arranged on the top side of the substrate 19.

The microscope according to the invention further comprises image processing means such as a processing module 22. The processing module 22 may comprise, in a non-limitative way, a computer, a microprocessor, a controller board, with interfacing hardware such as analogic to digital converters and I/O boards. The processing means are configured to process the acquired image(s) in order to detect features of the substrate 19, and to determine relative lateral data of these features.

Advantageously, the microscope 100 further comprises a controller for the spatial light modulator 17. The controller is preferably implemented with the processing module 22, as illustrated in FIGURE 2. Alternatively, it may also be implemented as a separate controller.

The microscope 100 may also comprise a controller for the displaceable support. This controller is also preferably implemented with the processing module 22, as illustrated in FIGURE 2. Alternatively, it may also be implemented as a separate controller.

Light propagating through different optical path lengths within a spatial phase mask acquires different phase shifts. By modulating the optical path of the light beam by means of the phase mask, a desired phase profile can be achieved. The point spread function of the imaging system is thereby modified, and the depth of field may be extended.

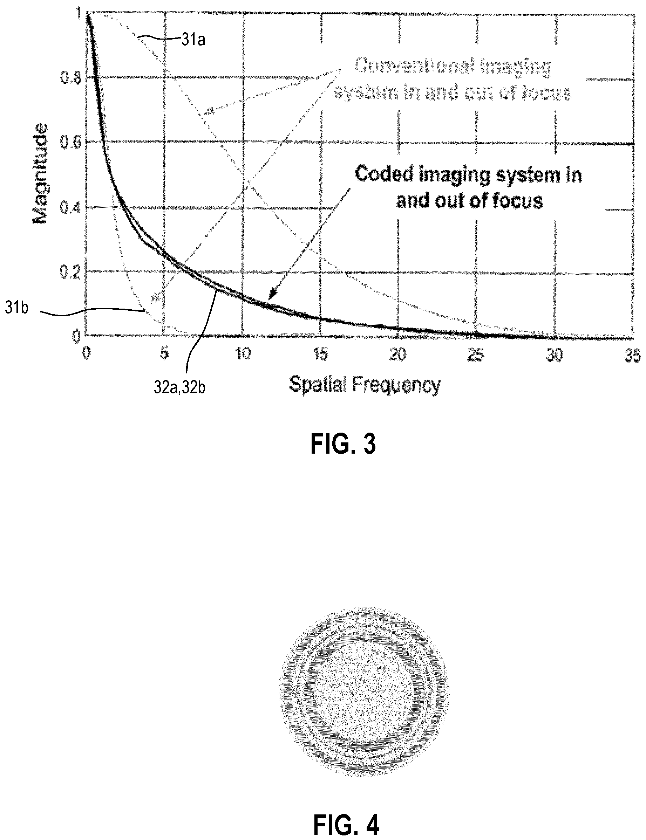

FIGURE 3, reproduced from W. T. Cathey and E. R. Dowski, "New paradigm for imaging systems", APPLIED OPTICS Vol. 41, No. 29, 2002, illustrates how optical transfer functions, corresponding to the point spread function in the frequency domain, can be modified using a spatial phase mask. The optical transfer functions 31a, 31b are obtained with an objective without spatial phase mask ("Conventional imaging system in and out of focus"). The functions 31a, 31b are obtained, respectively, for a position of an object or a feature at the best focus position, and at a more remote position. The optical transfer functions 32a, 32b are obtained with an objective with a phase mask, for the same respective positions of the object ("Coded imaging system in and out of focus"). It can be observed that the functions 32a, 32b are very similar, thus achieving the expected extension of the depth of focus.

It is to be noted that the extension of the depth of field is obtained at the expense of a loss of performance in the higher spatial frequencies, compared to the optical transfer function at best focus without phase mask. However, provided that the optical transfer function is carefully engineered as explained below to avoid, or at least minimize, zero of transmission in a useful frequency range, the loss in higher spatial frequencies can be at least partially recovered by applying a deconvolution or inverse filtering step at the resulting image, based on the optical transfer function. For instance, an averaged Wiener filter, known to minimize the mean squared error between the deconvolved image and the ideal one, can be used.

The spatial phase mask may be a dynamic phase modulator, as detailed with reference to FIGURE 2. A dynamically controlled phase-mask design allows real-time tuning of the extension of the depth of field to the application at hand.

The spatial phase mask may also be a binary phase mask. An example of a binary phase mask is shown in FIGURE 4. A binary phase mask has concentric rings, each ring adding a phase to the incident wave of 0 or **π** radians at the nominal wavelength **λ** of the incident light, thus modulating its point spread function. The phase difference can be obtained using different thicknesses of material between the rings, the difference in optical phase depending on the thickness and the refractive index of the material. With careful choice of the design, such a binary phase mask is particularly effective in extending the depth of field because it modulates the point spread function in a way that it remains invariant to defocus aberration over an extended range.

Alternatively, the spatial phase mask may be a cubic phase mask, providing smoother control over defocus by providing a more gradual transition between in-focus and out-of-focus regions.

Still another type of a spatial phase mask is a polynomial phase mask. Polynomial phase masks, based on polynomial functions, allow a highly customized modulation of the wavefront and therefore offer even greater flexibility in a multitude of applications.

The static types of spatial phase masks may be manufactured on fused silica substrates using ultraviolet photolithography associated with reactive ion etching followed by inductive coupled plasma etching (RIE-ICP).

When designing a spatial phase mask, the depth of field of an imaging system is optimized while maintaining high image quality. Critical input parameters such as the longitudinal positions of the focusing plane and the image sensor along the optical axis are defined, enabling for the calculation of the optical transfer function (OTF). The OTF is the Fourier transform of the point spread function and thus a mathematical representation of the system's spatial frequency transmission.

The OTF is essential for understanding how well the system maintains contrast and handles phase shifts under different focus conditions.

The real part of OTF is directly linked to the modulation transfer function (MTF) which represents the system's ability to maintain contrast at different spatial frequencies.

The imaginary part of the OTF is equally important as it encodes the phase information of the system. The phase information concerns the spatial frequency shift with defocus and the presence of any phase inversions that occur over the extended depth of field. Phase inversions can lead to distortions in the image.

Therefore, the spatial phase mask must be designed in a way that minimizes phase inversions, or allows the system to extract useful information from the phase inversions.

When designing a spatial phase mask, contrast and phase maps are used to visualize the imaging system's performance. The contrast map links the image clarity to different focus levels of the imaging system. The phase map links the image quality to phase shifts. These maps may be used conjointly to define the focusing depth domain, i.e., the range of spatial frequencies over which the imaging system maintains acceptable levels of focus and contrast.

During the phase mask design, the phase mask's performance may be improved by adjusting the phase function iteratively to enhance the system's modulation transfer function (MTF), i.e., the real part of the OTF. The phase shifts introduced by the mask are carefully chosen to maximize the MTF, ensuring that image details are preserved even when structures or objects move in and out of focus.

The spatial phase mask may be evaluated through simulations and experimental setups, focusing on metrics such as the phase map and the MTF. The transmission of spatial frequencies by the imaging system can thus be measured.

The microscope 100 may be implemented in a method according to the invention, in order to determine relative lateral data of features of a semiconductor substrate.

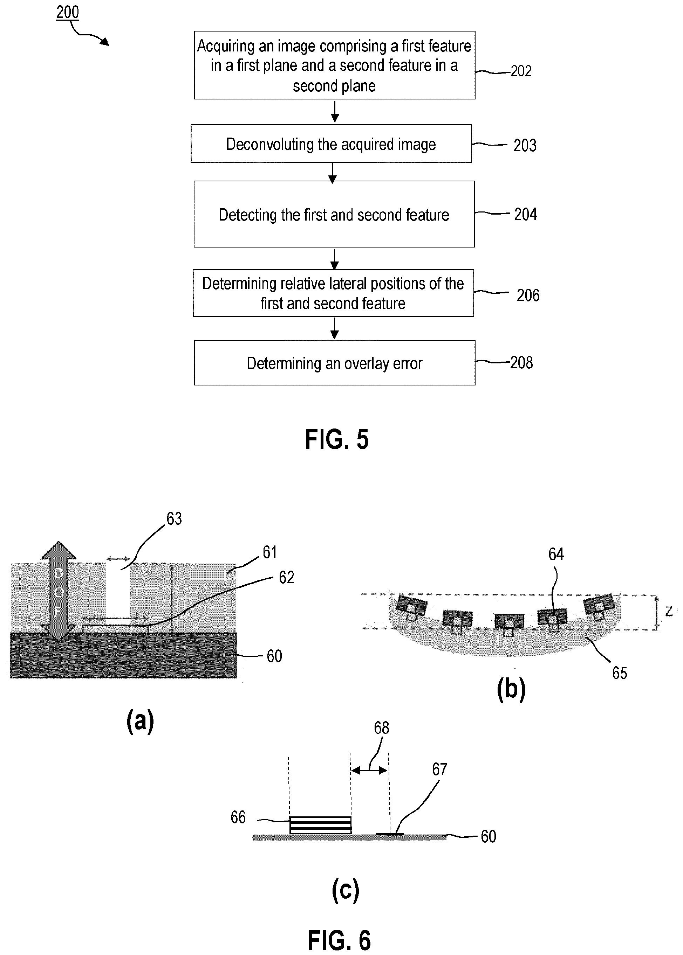

FIGURE 5 is a diagrammatic representation of a non-limitative example of a method according to the present invention. The method may be carried out by a device or a microscope according to the invention, and in particular by the imaging microscope 100 as represented in FIGURE 2.

The method 200, as illustrated in FIGURE 5, may be used to determine relative lateral data of features of a semiconductor substrate, such as the relative position of alignment marks, or the relative position of a structure with respect to another structure (vias, dies, etc.).

The method 200 comprises a step 202 of acquiring an image of a scene, and in particular of a semiconductor substrate such as a wafer, by an image sensor such as a camera. The semiconductor substrate comprises at least two features in different planes of depth, i.e., the planes being perpendicular to an optical axis of the imaging system. For this, the semiconductor substrate is illuminated by a light source positioned on a top and/or on a bottom side of the substrate, and of which the emitted light has a wavelength adapted to be transmitted through the substrate.

The planes in which the different features are situated are separated by a distance greater than the depth of field of the imaging system.

For the acquisition step 202, the imaging system of the device is provided with a spatial phase mask positioned in the aperture plane of the imaging system, or in the conjugate plane of the aperture plane of the imaging system, as described with reference to FIGURE 2, illustrating an embodiment of a device according to the invention.

Thanks to the presence of the spatial phase mask, the optical transfer function of the imaging system is modulated such that is depth of field is extended. The extended depth of field then accommodates the features present in different planes such that the features are imaged in sufficient or acceptable quality.

The method then comprises an optional step 203 of deconvoluting the acquired image, to improve the resolution.

As mentioned above, a deconvolution filter can be used to realize this step 203.

The deconvolution filter is used to separate the real and imaginary parts of the OTF, which are convoluted within the image(s). The real and imaginary parts may then be balanced in order to control contrast and phase inversions, the latter allowing for reducing image distortions.

During a detection step 204 of the method 200, features in different depth planes are detected and their relative lateral positions are determined.

At least a first and a second feature are detected in the image. The first and second features belong to different depth planes.

The detection of the features may be realized according to known image processing techniques.

Following the detection step 204, the method 200 comprises a determination step 206 during which relative lateral data of the first feature and the second feature are determined.

According to an example, the relative lateral data of two or more features may comprise relative lateral dimensions of these features.

According to another example, the relative lateral data of two or more features may comprise relative lateral positions of these features.

FIGURE 6 illustrates examples of implementations of the method and the device according to the present invention.

In FIGURE 6(a), both a photoresist layer 61 and a structure 62 are deposited on a substrate 60. The position of an opening 63 in the photoresist layer 61 relative to the underlying structure 62 on the substrate 60 must be controlled. The position and size of the opening 63 must also be measured. The opening 63 can be a hole, or a trench. The photoresist layer 61 may have a thickness of, for example, 30-50 µm.

In FIGURE 6(b), structures 64 must be imaged to control for instance their relative placement. The structures 64 are on the surface of a highly warped wafer 65, and so they are not in the same plane, i.e., not in the same depth z.

In the example of FIGURE 6(c), it is necessary to measure the placement 68 of a die or a die stack 66 with respect to another pattern 67 on the surface of the substrate 60, such as a scribe line. Each die can be 40-50 µm thick.

In the examples illustrated in FIGURE 6(a)-(c), the different features may be separated by several tens of micrometres in depth (z direction). The extended depth of field of the imaging system of the microscope or the device according to the invention accommodates all of the features, structures, layers, etc., as indicated in FIGURE 6(a) ("DOF").

The method 200 according to the embodiment as represented in FIGURE 5 further comprises a step 206 of determining an overlay error from the relative lateral data.

The overlay error takes account of the correct alignment between vertically stacked features, like layers or structures.

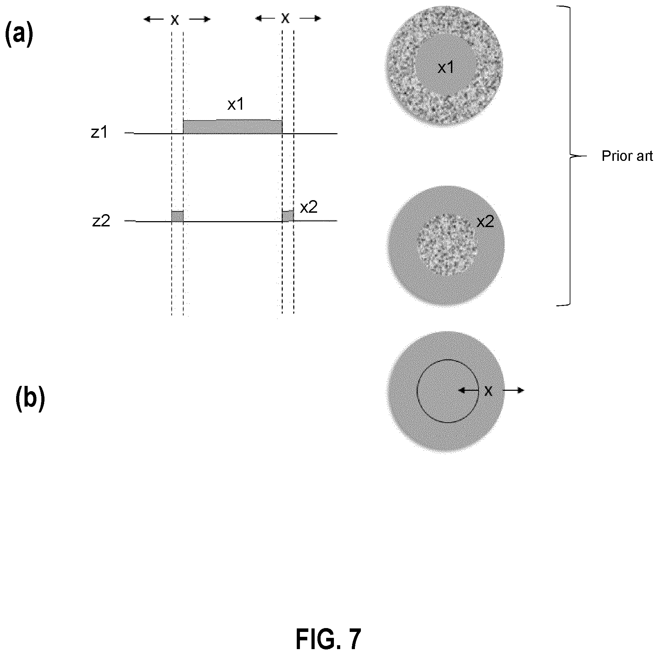

An example illustrating overlay or relative position measurements by means of a method and a device according to the invention, compared to prior art, is shown in FIGURE 7.

In this example, the overlay measurements are carried out at structures in different planes, i.e., located at different heights z1, z2 with respect to a semiconductor substrate. The first structure is a disk having a diameter of x1, and the second structure is a ring having an inner diameter of x1 and an outer diameter of x1 +2·x2. The relative position x in the plane between the first structure at depth z1 and the second structure at depth z2 is to be retrieved.

In FIGURE 7(a), the measurement is carried out with a system having a limited, or standard, depth of field. It is necessary to acquire a first image of the first structure at depth z1, in order to determine the position x1 of that first structure. It is then necessary to acquire a second image of the second structure at depth z2 to determine the position x2 of that second structure. The relative position x of the two structures can then be calculated as a difference between x1 and x2. Thus, the measurement requires the acquisition and processing of two images.

In FIGURE 7(b), the method and the device according to the invention, implementing an imaging system with an extended depth of field, are used. The two structures can be imaged in a single image with sufficient sharpness and precision. The relative position x of the two structures is directly calculated from this one image.

Of course, the invention is not limited to the examples detailed above.

## Claims

1. A method (200) for determining relative lateral data of features of a semiconductor substrate, the method (200) being implemented by a device comprising:
- an imaging system (11, 13, 14, 16) having a depth of field,
- a spatial phase mask (17) positioned in the aperture stop of the imaging system (11, 13, 14, 16) or in a conjugate plane of the aperture stop and configured to modulate the optical transfer function of the imaging system, and
- an image sensor (12),
wherein the modulated optical transfer function is adapted to extend the depth of field of the imaging system,
the method (200) comprising the following steps:
- acquiring (202) an image of a scene comprising at least a first feature of the semiconductor substrate in a first plane and a second feature of the semiconductor substrate in a second plane, the planes being perpendicular to an optical axis of the imaging system and separated by a distance greater than the depth of field of the imaging system;
- detecting (204) the first feature of the semiconductor substrate and the second feature of the semiconductor substrate;
- determining (206) relative lateral data of the first feature and the second feature.

2. The method (200) according to claim 1, wherein the relative lateral data comprise relative lateral dimensions of the first and second feature, respectively.

3. The method (200) according to claim 1 or 2, wherein the relative lateral data comprise relative lateral positions of the first and second feature, respectively.

4. The method (200) according to any one of the preceding claims, further comprising a step (208) of determining an overlay error from the relative lateral data.

5. The method (200) according to any one of the preceding claims, further comprising a step of determining a shape of the first feature and/or the second feature.

6. The method (200) according to any one of the preceding claims, further comprising a step (203) of deconvoluting the acquired image using a deconvolution filter.

7. Device for determining relative lateral data of features of a semiconductor substrate, comprising:
- an imaging system (11, 13, 14, 16) having a depth of field;
- a spatial phase mask (17) positioned in the aperture stop of the imaging system (11, 13, 14, 16) or in a conjugate plane of the aperture stop, the spatial phase mask (17) being configured to modulate the optical transfer function of the imaging system, wherein the modulated optical transfer function is adapted to extend the depth of field of the imaging system;
- an image sensor (12) for acquiring, through the imaging system, an image of a scene comprising at least a first feature of the semiconductor substrate in a first plane and a second feature of the semiconductor substrate in a second plane, the planes being perpendicular to an optical axis of the imaging system and are separated by a distance greater than the depth of field of the imaging system;
- processing means (22) configured to:
▪ detect the first feature of the first semiconductor substrate and the second feature of the second semiconductor substrate,
▪ determine relative lateral data of the first feature and the second feature.

8. The device according to the preceding claim, wherein the spatial phase mask (17) is realized on a fused silica substrate.

9. The device according to claim 6, wherein the spatial phase mask (17) comprises a dynamic phase modulator.

10. The device according to any one of claims 7 to 9, wherein the spatial phase mask comprises one of:
- an binary phase mask,
- a cubic phase mask,
- a polynomial phase mask.

11. An imaging microscope (100) comprising a light source (102) and a device according to any one of claims 7 to 10.
